# EUROPÄISCHE PATENTSCHRIFT

(11) **EP 3 740 050 B1**
(45) Veröffentlichungstag und Bekanntmachung des Hinweises auf die Patenterteilung: **06.11.2024**
(21) Anmeldenummer: 20169307.4
(22) Anmeldetag: 14.04.2020
(51) Int. Cl.: H01R 12/57, H01R 12/70, H01R 12/75, H05K 5/00

(54) **LEITERPLATTE MIT EINER STECKVERBINDUNG**
PRINTED CIRCUIT BOARD WITH A CONNECTOR
CARTE DE CIRCUIT IMPRIMÉ DOTÉE D'UN CONNECTEUR ENFICHABLE

(30) Priorität: 17.05.2019 DE 102019113068
(43) Veröffentlichungstag der Anmeldung: 18.11.2020
(73) Patentinhaber: Marelli Automotive Lighting Reutlingen (Germany) GmbH, 72762 Reutlingen (DE)
(72) Erfinder: Holder, Ulrich, 72587 Römerstein (DE); Rubil, Sinisa, 72793 Pfullingen (DE)
(74) Vertreter: DREISS Patentanwälte PartG mbB

(56) Entgegenhaltungen:
- EP-A1- 2 928 022
- EP-A2- 1 814 199
- EP-A2- 1 830 432
- DE-U1- 29 603 390
- FR-A1- 2 721 161
- JP-A- 2000 077 121
- US-A1- 2011 182 043

## Beschreibung

Die vorliegende Erfindung betrifft ein Steuergerät mit einer Leiterplatte gemäß Anspruch 1.

Ein Steuergerät gemäß dem Oberbegriff von Anspruch 1 ist bereits aus der Druckschrift DE 296 03 390 U1 bekannt. EP 2 928 022 A1 offenbart ein Steuergerät mit einer Leiterplatte die ein erstes Steckerelement aufweist, das dazu eingerichtet ist, mit einem zweiten Steckerelement zu einer Steckerverbindung zusammengefügt zu werden. Die Leiterplatte weist eine mit ersten Bauelementen bestückte und Leiterbahnen aufweisende erste Seite und eine zweite Seite auf. Das erste Steckerelement ist in einem Kontakt- und Befestigungsbereich der ersten Seite mechanisch fest mit der ersten Seite der Leiterplatte verbunden. Der Kontakt- und Befestigungsbereich weist erste elektrische Kontakte auf, die durch auf oder innerhalb der Leiterplatte verlaufende metallische Strukturen mit wenigstens einem der Bauelemente elektrisch leitfähig verbunden sind. Das erste Steckerelement ist dazu eingerichtet, mechanisch fest mit einem zweiten Steckerelement verbunden zu werden, das zweite elektrische Kontakte aufweist, die dann, wenn das erste Steckerelement mechanisch fest mit dem zweiten Steckerelement verbunden ist, elektrisch leitfähig mit den ersten elektrischen Kontakten verbunden sind.

Bei dem bekannten Steuergerät bildet die Leiterplatte eine Wand des Steuergeräts. Die erste Seite der Leiterplatte ist einem Innenraum des Steuergeräts zugewandt. Die Leiterplatte weist eine Öffnung auf, in der das erste Steckerelement angeordnet ist. Das erste Steckerelement deckt die Öffnung ab, wobei es an einem Rand der Öffnung an der ersten Seite der Leiterplatte befestigt ist. Die Befestigung liegt damit im Innenraum des Steuergeräts. Erste elektrische Kontakte ragen vom ersten Steckerelement ausgehend in die Öffnung. Ein zweites Steckerelement, das ein Ende eines Kabelbaums bildet, kann mit zweiten elektrischen Kontakten in die Öffnung eingeführt und mit dem ersten Steckerelement mechanisch und elektrisch gekoppelt werden.

Bekannt sind auch Steuergeräte mit Leiterplatten, bei denen die Steckverbindung mit einer als "Press Fit" bekannten Steckertechnologie hergestellt wird. Bei dieser Technologie weist die Leiterplatte Metallhülsen (Durchkontaktierungen) auf, welche die erste Seite der Leiterplatte mit der zweiten Seite der Leiterplatte verbinden. In diese Metallhülsen werden Metallstifte eingepresst, die dann in ihrer Gesamtheit ein erstes Steckerelement bilden, das in einem Kontakt- und Befestigungsbereich der ersten Seite lokalisiert ist.

Da die Metallstifte in Verbindung mit den Durchkontaktierungen aus beiden Seiten der Leiterplatte herausragen, kann die Leiterplatte in einem dem Kontakt- und Befestigungsbereich der ersten Seite entsprechenden und dem Kontakt- und Befestigungsbereich der ersten Seite gegenüberliegenden Bereich der zweiten Seite nicht zur Anordnung von Bauelementen und/oder Leiterbahnen genutzt werden. Dies gilt auch für ein aus der US 4 826 442 bekanntes Steckerelement, das eine Reihe von Lötzungen (dort "integral solder tails 28") aufweist, die alle eine Leiterplatte (dort "circuit board 48") durchdringen.

Aus der Druckschrift EP 1 830 432 A2 ist eine Steckverbindung bekannt, bei der die Verbindungsrichtung und die Löserichtung parallel zu einer Leiterplatte liegen. Aus der JP 2000 077121 ist eine Leiterplatte bekannt, bei der Kontakte eines Steckerelements sowohl auf einer ersten Seite einer Leiterplatte angeordnet sind als auch als Durchkontaktierung auf einer der ersten Seite gegenüberliegenden zweiten Seite angeordnet sind. US 2011/182043 A1 offenbart eine Leiterplatte, die für SMD-Bauteile ausgelegt ist und daher nur Bohrungen zur Befestigung der Leiterplatte bzw. zur Fixierung auf dem Kunststoffboden oder in Verbindung mit dem Kunststoffdeckel aufweist. Die Leiterplatte nimmt verschiedene elektrische Bauteile und Stiftleisten auf, die die Verbindung zur Schnittstelle im Kunststoffdeckel herstellen. Die Bauteile und auch die Stiftleiste werden auf der Leiterplatte durch ein sogenanntes Reflow-Verfahren fixiert und dabei fest verlötet. Die Stiftleiste ist in SMD-Technik ausgeführt.

Von dem eingangs genannten Stand der Technik unterscheidet sich die vorliegende Erfindung durch die kennzeichnenden Merkmale des Anspruchs 1.

Dadurch, dass das erste Steckerelement vollständig in einem von der ersten Seite der Leiterplatte begrenzten ersten Innenraumbereich liegt, der von einem von der zweiten Seite begrenzten zweiten Innenraumbereich durch die Leiterplatte getrennt ist, ist es erst möglich, einen dem Kontakt- und Befestigungsbereich der ersten Seite gegenüberliegenden Bereich der zweiten Seite dazu zu nutzen, dort elektrische Bauelemente anzuordnen und/oder Leiterbahnen verlaufen zu lassen.

Diese Merkmale lösen daher die Aufgabe, die Fläche einer Leiterplatte besser auszunutzen. Die Erfindung ermöglicht eine Anordnung einer bestimmten Anzahl von Bauelementen, die nach dem Stand der Technik eine bestimmte Größe der Leiterplatte und damit des Steuergeräts erfordern, auf einer kleineren Leiterplatte, ohne dabei Funktionseinbußen in Kauf nehmen zu müssen.

Eine bevorzugte Ausgestaltung des Steuergeräts zeichnet sich dadurch aus, dass das erste Steckerelement als ein SMD-Bauteil mechanisch fest mit der Leiterplatte verbunden ist.

Bevorzugt ist auch, dass die Verbindung des ersten Steckerelementes mit der Leiterplatte eine Lötverbindung ist.

Weiter ist bevorzugt, dass das erste Steckerelement mit an Ecken des Steckerelements lokalisierten Lötpads der Leiterplatte verbunden ist.

Eine weitere bevorzugte Ausgestaltung zeichnet sich dadurch aus, dass elektrische Verbindungen von Kontakten des ersten Steckerelements zu Leiterbahnen und/oder anderen elektrischen Kontakten der Leiterplatte gelötete Verbindungen sind.

Bevorzugt ist auch, dass die Leiterplatte einen dielektrischen Träger aufweist, der eine erste Breitseite und eine zweite Breitseite aufweist, wobei die erste Breitseite eine in Form von Leiterbahnen und metallischen Funktionsflächen strukturierte Metallschicht aufweist und wobei die zweite Breitseite eine in Form von Leiterbahnen und metallischen Funktionsflächen strukturierte zweite Metallschicht aufweist.

Weiter ist bevorzugt, dass der dielektrische Träger aus einer Einzellage aus dielektrischem Material besteht.

Eine weitere bevorzugte Ausgestaltung zeichnet sich dadurch aus, dass der dielektrische Träger wenigstens zwei Lagen aus dielektrischem Material aufweist.

Bevorzugt ist auch, dass zwischen zwei Lagen aus dielektrischem Material eine in Leiterbahnen und/oder Funktionsflächen strukturierte metallische Schicht angeordnet ist.

Erfindungsgemäß weist das Steuergerät ein Gehäuse auf, das einen Innenraum des Steuergerätes begrenzt, und die Leiterplatte ist so in dem Gehäuse angeordnet, dass die Leiterplatte den Innenraum in einen von der ersten Seite begrenzten ersten Innenraumbereich und einen von der zweiten Seite begrenzten zweiten Innenraumbereich aufteilt.

Erfindungsgemäß sind auf der ersten Seite der Leiterplatte Lötpads angeordnet, an die erste Kontakte angelötet sind, wobei die ersten Kontakte SMD-Lötkontakte sind, die nicht durch die Leiterplatte hindurchdringen, und dass das Steuergerät eine elektrisch isolierende Pinhalterung aufweist, in welche Abschnitte der ersten Kontakte eingebettet sind.

Erfindungsgemäß stützt sich die elektrisch isolierende Pinhalterung auf der Innenseite des Steuergerätegehäuses an diesem anstoßend ab.

Bevorzugt ist auch, dass die elektrisch isolierende Pinhalterung aus einem elektrisch isolierenden und mechanisch formstabilen Kunststoff besteht.

Weiter ist bevorzugt, dass die elektrisch isolierende Pinhalterung einen Positionierzylinder aufweist, der genau passend in eine zu seiner Form komplementäre Aussparung in der Leiterplatte eingesetzt wird.

Eine weitere bevorzugte Ausgestaltung zeichnet sich dadurch aus, dass sich auf der zweiten Seite der Leiterplatte, gegenüber von dem Bereich der ersten Leiterplatte, an dem die ersten Kontakte angeordnet sind, mindestens ein Abstandshalter befindet, der durch seine Form und Anordnung dazu eingerichtet ist, eine beim Zusammenstecken des ersten Steckerelements und des zweiten Steckerelements auftretende Durchbiegung der Leiterplatte zu begrenzen.

Weitere Vorteile ergeben sich aus der nachfolgenden Beschreibung, den Zeichnungen und den Unteransprüchen. Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in den Zeichnungen dargestellt und werden in der nachfolgenden Beschreibung näher erläutert.

Dabei zeigen, jeweils in schematischer Form:
Figur 1 eine perspektivische Ansicht einer Leiterplatte mit einer Steckverbindung;
Figur 2 einen Schnitt durch den Gegenstand der Figur 1;
Figur 3 zwei Seiten einer Leiterplatte eines bekannten Steuergeräts mit einer Aufteilung in verschiedene Bereiche;
Figur 4 zwei Seiten einer Leiterplatte eines bekannten Steuergeräts mit einer Aufteilung in verschiedene Bereiche und
Figur 5 einen Querschnitt eines Ausführungsbeispiels eines erfindungsgemäßen Steuergerätes.

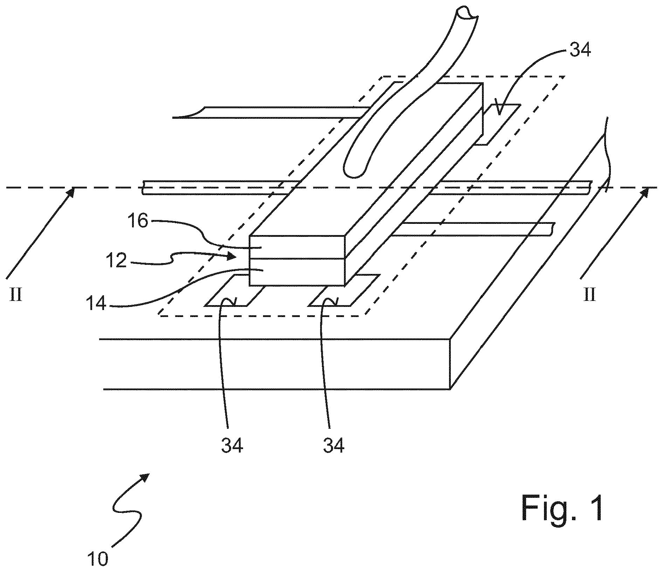

Im Einzelnen zeigt die Figur 1 eine Leiterplatte 10 mit einer Steckverbindung 12 aus einem ersten Steckerelement 14 und einem zweiten Steckerelement 16. Die Leiterplatte 10 weist eine mit ersten Bauelementen 18 bestückte und Leiterbahnen 20 aufweisende erste Seite 22 auf.

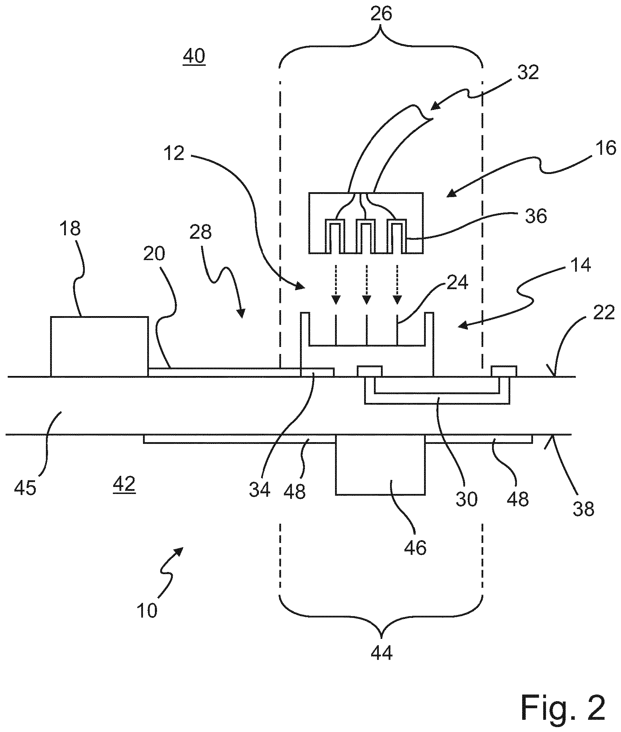

Das erste Steckerelement 14 ist in einem Kontakt- und Befestigungsbereich 26 (vergleiche Figur 2) der ersten Seite 22 mechanisch fest mit der ersten Seite 22 der Leiterplatte 10 verbunden.

Das erste Steckerelement 14 weist erste elektrische Kontakte 24 auf, die durch auf oder innerhalb der Leiterplatte 10 verlaufende metallische Strukturen 28 mit wenigstens einem der ersten Bauelemente 18 elektrisch leitfähig verbunden sind. Die metallischen Strukturen 28 sind zum Beispiel auf der ersten Seite 22 verlaufende Leiterbahnen 20, auf der einer zweiten Seite 38 der Leiterplatte 10 verlaufende Leiterbahnen, die mittels metallischer Durchkontaktierungen mit metallischen Strukturen auf der ersten Seite 10 verbunden sind, oder in der Leiterplatte 10 verlaufende metallische Strukturen 30 wie Leiterbahnen, die mittels Durchkontaktierungen mit der ersten Seite 10 elektrisch leitend verbunden sind.

Das erste Steckerelement 14 ist dazu eingerichtet, mechanisch fest mit dem zweiten Steckerelement 16 verbunden zu werden. Das zweite Steckerelement 16 ist im dargestellten Beispiel mit einem Kabelbaum 32 verbunden, mit dem die Leiterplatte 10 zum Beispiel an ein Bordnetz eines Kraftfahrzeuges anschließbar ist. Das erste Steckerelement 14 ist bevorzugt als ein SMD-Bauteil mechanisch fest mit der Leiterplatte 10 verbunden. Die Verbindung ergibt sich bevorzugt durch einen Lötvorgang.

Figur 2 zeigt einen Schnitt durch den Gegenstand der Figur 1. Im Einzelnen zeigt die Figur 2 die Leiterplatte 10 mit einer Steckverbindung 12 aus dem ersten Steckerelement 14 und dem zweiten Steckerelement 16. Wie Figur 1 zeigt, ist das erste Steckerelement 14 mit an Ecken des ersten Steckerelements 14 lokalisierten Lötpads 34 der Leiterplatte 10 verbunden. Elektrische Verbindungen von ersten elektrischen Kontakten 24 des ersten Steckerelements 14 zu Leiterbahnen und/oder anderen elektrischen Kontakten der Leiterplatte 10 sind bevorzugt ebenfalls gelötet.

Das erste Steckerelement 14 ist in dem Kontakt- und Befestigungsbereich 26 der ersten Seite 22 mechanisch fest mit der ersten Seite 22 der Leiterplatte 10 verbunden. Das erste Steckerelement 14 weist erste elektrische Kontakte 24 auf, die durch auf oder innerhalb der Leiterplatte 10 verlaufende metallische Strukturen 28, 30 mit wenigstens einem der ersten Bauelemente 18 elektrisch leitfähig verbunden sind. Das erste Steckerelement 14 ist dazu eingerichtet, mechanisch fest mit dem zweiten Steckerelement 16 verbunden zu werden.

Das zweite Steckerelement 16 weist zweite elektrische Kontakte 36 auf, die dann, wenn das erste Steckerelement 14 mechanisch fest mit dem zweiten Steckerelement 16 verbunden ist, elektrisch leitfähig mit den ersten elektrischen Kontakten 24 verbunden sind.

Die elektrische Verbindung des zweiten Steckerelements 16 mit dem ersten Steckerelement 14 liegt vollständig in einem von der ersten Seite 22 der Leiterplatte 10 begrenzten ersten Innenraumbereich 40 eines in der Figur 1 nicht dargestellten, die Leiterplatte aufnehmenden und weitgehend umgebenden Gehäuse eines Steuergeräts. Der erste Innenraumbereich 40 ist in der Figur 1 ein oberhalb der Leiterplatte 10 lokalisierter Innenraumbereich.

Die Leiterplatte 10 weist zusätzlich zur mit ersten Bauelementen 18 bestückten und Leiterbahnen 20 aufweisenden ersten Seite 22 die zweite Seite 38 auf. Ein zweiter Innenraumbereich 42 liegt in der Figur 1 unterhalb der Leiterplatte 10. Dieser zweite Innenraumbereich 42 wird nach oben von der zweiten Seite 38 der Leiterplatte 10 und nach unten sowie zu den Seiten von dem in der Figur 1 nicht dargestellten Gehäuse begrenzt. Der erste Innenraumbereich 40 wird durch die Leiterplatte 10 von dem zweiten Innenraumbereich 42 getrennt.

Die zweite Seite 38 der Leiterplatte 10 weist einen dem Kontakt- und Befestigungsbereich 26 der ersten Seite 22 gegenüberliegenden Kontakt- und Befestigungsbereich 44 auf, in dem zweite elektrische Bauelemente 46 angeordnet sind und/oder in dem Leiterbahnen 48 verlaufen.

Die Leiterplatte 10 weist einen dielektrischen Träger 45 auf, der eine erste Breitseite in Form der ersten Seite 22 und eine zweite Breitseite in Form der zweiten Seite 38 aufweist. Die erste Breitseite weist eine in Form von Leiterbahnen 20 und metallischen Funktionsflächen strukturierte Metallschicht auf. Die zweite Breitseite weist ebenfalls eine in Form von Leiterbahnen 48 und metallischen Funktionsflächen strukturierte zweite Metallschicht auf. Der dielektrische Träger 45 besteht in einer Ausgestaltung aus einer Einzellage aus dielektrischem Material, er kann aber auch einen Mehrlagenschichtstapel aus wenigstens zwei Lagen aus dielektrischem Material aufweisen. Zwischen zwei solchen Lagen aus dielektrischem Material kann eine in metallische Strukturen 30 (zum Beispiel Leiterbahnen) und/oder Funktionsflächen strukturierte metallische Schicht angeordnet sein.

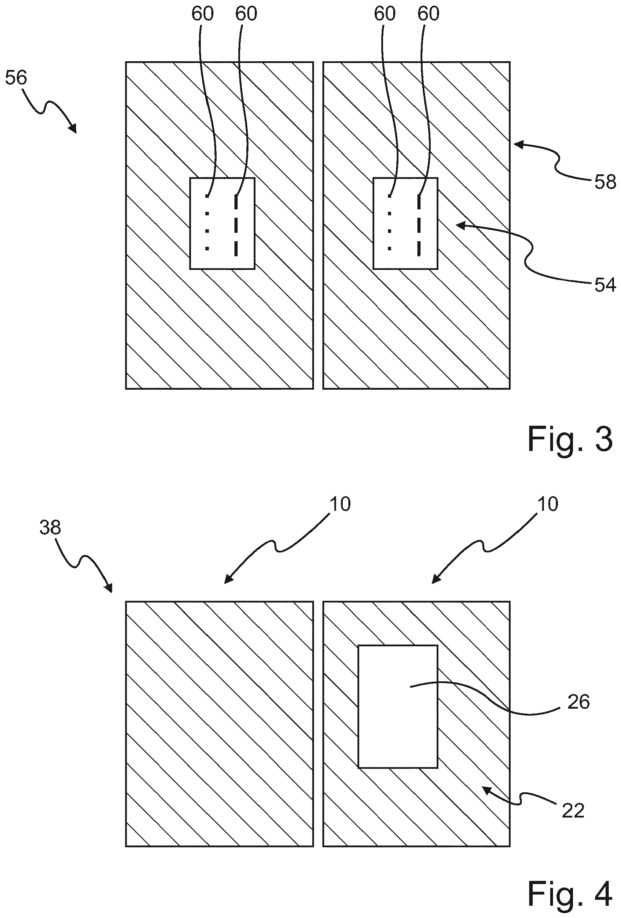

Die Figuren 3 und 4 veranschaulichen den Vorteil der erfindungsmäßen Leiterplatte 10 gegenüber dem eingangs genannten Stand der Technik. In beiden Figuren 3, 4 ist der schraffierte Bereich jeweils ein Bereich, der für die Bestückung mit Bauelementen und deren Kontaktierung verwendbar ist, während das nicht schraffierte innere Rechteck jeweils für die Kontaktierung der Leiterplatte 10 insgesamt, beispielsweise durch einen Kabelbaum, dient.

Figur 3 zeigt eine bekannte Leiterplatte mit "Press-Fit" Kontaktierung in einem Kontakt- und Befestigungsbereich 54. Der linke Teil der Figur 3 zeigt eine erste Seite 56 der bekannten Leiterplatte, während der rechte Teil der Figur eine zweite Seite 58 der Leiterplatte zeigt. Bei der Press-Fit-Kontaktierung ragen Kontaktstifte 60 oder Kontaktzungen in dem Kontakt- und Befestigungsbereich 54 jeweils aus beiden Seiten der Leiterplatte heraus, obwohl die Kontaktierung mit einem Steckerelement nur an einer der beiden Seiten, zum Beispiel an der ersten Seite 56 erfolgt. Die erste Seite ist zum Beispiel die in der Figur 3 links liegende Seite 56.

Der dem auf der ersten Seite (links) liegenden Anschlussbereich auf der zweiten Seite (rechts) gegenüberliegende Bereich 54 ist wegen der der dort funktionslos herausragenden Kontaktstifte oder Kontaktzungen 60 nicht für eine Anordnung von Bauelementen und/oder Leiterbahnen nutzbar. Dies gilt analog für den Stand der Technik nach der US 4 826 442, bei deren Gegenstand "integral solder tails 58" die ganze Dicke einer Leiterplatte durchdringen.

Auch bei der EP 2 928 022 A1 liegt auf beiden Seiten einer Leiterplatte ein Bereich, der nicht für eine Anordnung oder Kontaktierung von Bauelementen zur Verfügung steht. Bei dem Gegenstand dieser Schrift ergibt sich dies aus dem Umstand, dass ein Steckerelement auf einer Seite der Leiterplatte befestigt ist und die Steckverbindung von der anderen Seite der Leiterplatte aus durch eine Ausnehmung in der Leiterplatte hindurch erfolgt.

Figur 4 zeigt beide Seiten einer Leiterplatte 10 eines erfindungsgemäßen Steuergeräts. Diese unterscheidet sich von der Leiterplatte aus der Figur 3 dadurch, dass die zweite Seite 38 vollständig für die Anordnung und Kontaktierungen von elektrischen Bauelementen zur Verfügung steht. Die Kontaktierung der Leiterplatte 10 erfolgt in einem Kontakt- und Befestigungsbereich 26 auf der ersten Seite 22 der Leiterplatte 10. Der diesem Kontakt- und Befestigungsbereich 26 gegenüberliegende Bereich der zweiten Seite der Leiterplatte 10 steht zur Bestückung mit Bauelementen und zu deren Kontaktierung frei zur Verfügung, weil die elektrische Verbindung des zweiten Steckerelements mit dem ersten Steckerelement vollständig in einem von der ersten Seite der Leiterplatte begrenzten ersten Innenraumbereich liegt, der von einem von der zweiten Seite begrenzten Innenraumbereich durch die Leiterplatte getrennt ist. Die Summe der schraffierten Flächen der Figur 4 ist größer als die Summe der schraffierten Flächen der Figur 3, so dass die Leiterplattenfläche bei der Figur 4 besser ausgenutzt werden kann, d.h., bei gleichem Funktionsumfang und damit gleicher Zahl von gleichen Bauelementen kann die erfindungsgemäße Leiterplatte kleiner ausfallen als die bekannte Leiterplatte.

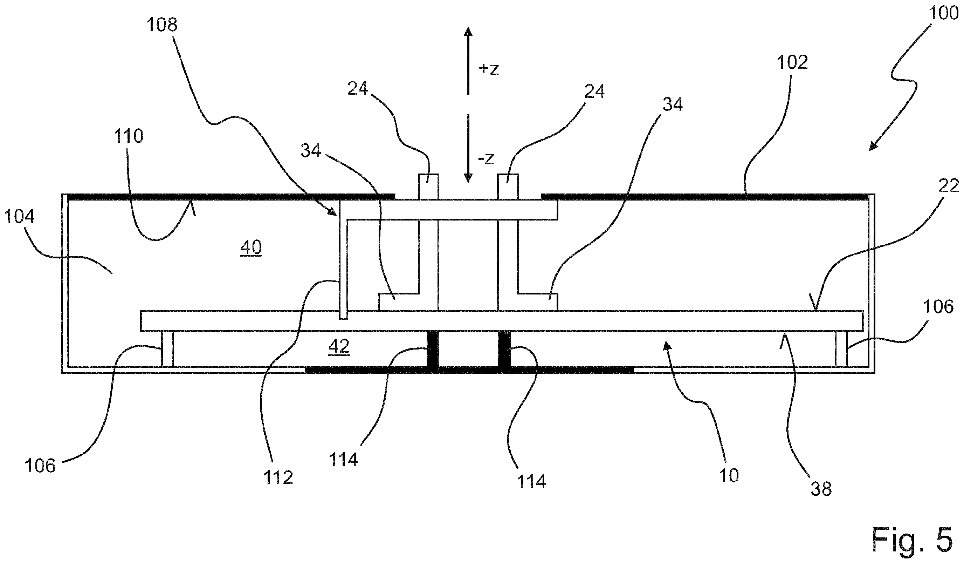

Figur 5 zeigt einen Schnitt eines erfindungsgemäßen Steuergerätes 100. Die Schnittebene liegt senkrecht zu der Fläche, in der sich die erste Seite 22 und die zweite Seite 38 der Leiterplatte 10 erstrecken. Das Steuergerät 100 weist ein Gehäuse 102 auf, das einen Innenraum 104 des Steuergerätes 100 begrenzt. Die Leiterplatte 10 teilt den Innenraum 104 in einen von der ersten Seite 22 begrenzten ersten Innenraumbereich 40 und einen von der zweiten Seite 38 begrenzten zweiten Innenraumbereich 42 auf. Auf der ersten Seite 22 der Leiterplatte 10 sind Lötpads 34 angeordnet, an die erste Kontakte 24 angelötet sind. Die ersten Kontakte 24 sind bevorzugt SMD-Lötkontakte. Die ersten Kontakte 24 dringen als SMD-Lötkontakte nicht durch die Leiterplatte 10 hindurch.

Diese auf der zweiten Seite 38 der Leiterplatte 10 vorteilhaft Platz sparende Anordnung der ersten Kontakte 24 geht mit dem Nachteil einher, dass die Verbindung der ersten Kontakte 24 mit ihren Lötpads 34 eine mechanische Festigkeit aufweist, die kleiner ist als die mechanische Festigkeit der Verbindung von die Leiterplatte durchdringenden Kontakten mit deren Lötpads beim Stand der Technik.

Zum Lösen wirkt eine Kraft in Plus-z-Richtung auf die ersten Kontakte 24 ein. Die Plus-z-Richtung steht zum Beispiel senkrecht auf der ersten Seite 22 der Leiterplatte 10 und ist von dieser weg gerichtet.

Wenn die als SMD-Pins realisierten Kontakte 24 nur an den Leiterbahnen befestigt wären, könnten sie sich beim Abziehen des zweiten Steckerelementes 16 lösen und Leiterbahnenabschnitte mitreißen. Die Leiterbahnen lösen sich bereits bei recht geringen Zugkräften von der Leiterplatte 10. Die geringere mechanische Festigkeit könnte dazu führen, dass sich die ersten Kontakte 24 beim Abziehen eines zweiten Steckerelementes 16 von einem ersten Steckerelement 14 einer Steckerverbindung 12 lösen.

Ein zu vermeidendes Lösen der ersten Kontakte 24 von den Lötpads 34 oder zumindest eine Beeinträchtigung der elektrischen Verbindungen zwischen den Lötpads 34 und den ersten Kontakten 24 kann auch beim Verbinden des zweiten Steckerelementes 16 mit dem ersten Steckerelement 14 auftreten. Beim Verbinden wirkt eine Kraft in Minus-z-Richtung auf die Leiterplatte 10 ein. Als Folge kann es bei einer Leiterplatte 10, die mit weit voneinander entfernten Stützen 106 mit dem Gehäuse 102 verbunden ist, zu einer Durchbiegung der Leiterplatte 10 in dem zwischen den Stützen 106 liegenden zentralen Teil der Leiterplatte 10 kommen, die zu einer mechanischen Beschädigung der Verbindung zwischen Lötpads 34 und ersten Kontakten 24 führt, die eine elektrische Leitfähigkeit dieser Verbindung beeinträchtigt.

Diese potenziell auftretenden Probleme werden mit bevorzugten Ausgestaltungen des Steuergeräts 100 vermieden, die im Folgenden erläutert werden: Um beim Lösen der Steckerverbindung 12 auftretende Belastungen der Verbindungen von ersten Kontakten 24 und Lötpads 34 zu verringern, werden die ersten Kontakte 24 mit einer elektrische isolierenden Pinhalterung 108 zusammengehalten.

Um die beim Lösen der Steckerverbindungen 12 auftretenden Kräfte aufzunehmen und eine Deformation der Leiterplatte 10 in Plus-z-Richtung zu verhindern, ist die elektrisch isolierende Pinhalterung 108 derart ausgeführt, dass sie auf der Innenseite 110 des Steuergerätegehäuses 102 anstößt. Damit ist gewährleistet, dass das zweite Steckerelement 16 von den ersten Kontakten 24 des ersten Steckerelements 14 abgezogen werden kann, ohne dass die SMD-Kontakte zu den Lötpads 34 unzulässig hohen Kräften ausgesetzt werden. Die elektrisch isolierende Pinhalterung 108 besteht zum Beispiel aus einem elektrisch isolierenden und mechanisch formstabilen Kunststoff. Die ersten Kontakte 24 sind mit einem Abschnitt ihrer Länge fest in das Material der Pinhalterung 108 eingebettet. Das Einbetten erfolgt zum Beispiel durch teilweise erfolgendes Umspritzen der Kontakte 24 bei einem Spritzgießen der Pinhalterung 108. Die ersten Kontakte 24 verbinden sich dabei so innig mit der Pinhalterung 108, dass auf die ersten Kontakte 24 in z-Richtung wirkende Kräfte auf die Pinhalterung 108 übertragen werden.

Zur Positionierung der ersten Kontakte 24 weist die elektrisch isolierende Pinhalterung 108 einen Positionierzylinder 112 auf, der genau passend in eine zu seiner Form komplementäre Aussparung in der Leiterplatte 10 eingesetzt wird. Der Positionierzylinder 112 ragt bevorzugt in die Leiterplatte 10 herein, aber nicht hindurch. Der Positionierzylinder 112 verrastet bevorzugt nicht. Die Aussparung kann als die Leiterplatte 10 durchdringendes Loch oder als Sackloch ausgeführt sein.

Auf der zweiten Seite 38 der Leiterplatte 10, gegenüber von dem Kontakt- und Befestigungsbereich 26 der ersten Seite 22, an der die ersten Kontakte 24 angeordnet sind, befindet sich mindestens ein Abstandshalter 114 im Steuergerätegehäuse 102. Der oder die Abstandshalter 114 haben die Funktion, eine Durchbiegung der Leiterplatte 10 in der zur Plus-z-Richtung entgegengesetzten Minus-z-Richtung zu begrenzen. Eine solche Durchbiegung kann insbesondere beim Zusammenstecken des ersten Steckerelements 14 und des zweiten Steckerelements 16 auftreten. Die Positionierung des Abstandshalters 114 und die Anordnung gegebenenfalls auf der zweiten Seite 38 der Leiterplatte 10 verlaufender Leiterbahnen 48 müssen miteinander koordiniert werden. Insgesamt bestehen hier auf jeden Fall Freiheitsgrade für die Anordnung von Leiterbahnen 48 und Bauteilen 46, die beim eingangs genannten Stand der Technik nicht vorhanden sind. Bei durchkontaktierten Steckverbindungen, wie sie beim eingangs genannten Stand der Technik verwendet werden, ist eine von der zweiten Seite der Leiterplatte her erfolgende Abstützung schwieriger zu realisieren. Der Abstandshalter ist in einer Ausgestaltung ein Bestandteil des Gehäuses 102. In einer anderen Ausgestaltung ist alternativ oder ergänzend ein Abstandshalter vorgesehen, der ein Bestandteil der Leiterplatte 10 ist.

## Patentansprüche

1. Steuergerät (100) mit einer Leiterplatte (10), die ein erstes Steckerelement (14) aufweist, das dazu eingerichtet ist, mit einem zweiten Steckerelement (16) zu einer Steckerverbindung (12) zusammengefügt zu werden, wobei die Leiterplatte (10) eine mit ersten Bauelementen (18) bestückte und Leiterbahnen (20) aufweisende erste Seite (22) und eine zweite Seite (38) aufweist, und wobei das erste Steckerelement (14) in einem Kontakt- und Befestigungsbereich (26) der ersten Seite (22) mechanisch fest mit der ersten Seite (22) der Leiterplatte (10) verbunden ist und erste elektrische Kontakte (24) aufweist, die durch auf oder innerhalb der Leiterplatte (10) verlaufende metallische Strukturen (28) mit wenigstens einem der ersten Bauelemente (18) elektrisch leitfähig verbunden sind, und wobei das erste Steckerelement (14) dazu eingerichtet ist, mechanisch fest mit dem zweiten Steckerelement (16) verbunden zu werden, wobei sich auf einer Seite der Leiterplatte (10), gegenüber von dem Bereich der Leiterplatte (10), an dem die ersten Kontakte (24) angeordnet sind, mindestens ein Abstandshalter (114) befindet, der durch seine Form und Anordnung dazu eingerichtet ist, eine beim Zusammenstecken des ersten Steckerelements (14) und des zweiten Steckerelements (16) auftretende Durchbiegung der Leiterplatte (10) in einer ersten Richtung (-Z) zu begrenzen, wobei das Steuergerät ein Gehäuse (102) aufweist, das einen Innenraum (104) des Steuergerätes (100) begrenzt, und dass die Leiterplatte (10) so in dem Gehäuse (102) angeordnet ist, dass die Leiterplatte (10) den Innenraum (104) in einen von der ersten Seite (22) begrenzten ersten Innenraumbereich (40) und einen von der zweiten Seite (38) begrenzten zweiten Innenraumbereich (42) aufteilt, wobei zur Herstellung der Steckerverbindung (12) eingerichtete elektrische Kontakte des ersten Steckerelements (14) vollständig in dem ersten Innenraumbereich (40) des Steuergeräts liegen, wobei das Steuergerät (100) eine Pinhalterung (108) aufweist, in welche Abschnitte der ersten Kontakte (24) eingebettet sind, und wobei sich die Pinhalterung (108) auf der Innenseite (110) des Steuergerätegehäuses (102) an diesem anstoßend abstützt,
**dadurch gekennzeichnet, dass**
die Pinhalterung (108) elektrisch isolierend ist und sich auf der Innenseite (110) des Steuergerätegehäuses (102) derart an diesem anstoßend abstützt, dass beim Lösen der Steckerverbindung (12) auftretenden Kräfte aufgenommen und eine Deformation der Leiterplatte (10) in eine der ersten Richtung (-z) entgegengerichtete zweite Richtung (+z) verhindert wird, dass die zweite Seite (38) einen dem Kontakt- und Befestigungsbereich (26) der ersten Seite (22) gegenüberliegenden Kontakt- und Befestigungsbereich (44) aufweist, in dem zweite elektrische Bauelemente (46) angeordnet sind und/oder in dem Leiterbahnen (48) verlaufen, dass auf der ersten Seite (22) der Leiterplatte (10) Lötpads (34) angeordnet sind, an die erste Kontakte (24) angelötet sind, wobei die ersten Kontakte (24) SMD-Lötkontakte sind, die nicht durch die Leiterplatte (10) hindurchdringen.

2. Steuergerät (100) nach Anspruch 1, **dadurch gekennzeichnet, dass** das erste Steckerelement (14) bevorzugt als ein SMD-Bauteil mechanisch fest mit der Leiterplatte (10) verbunden ist.

3. Steuergerät (100) nach Anspruch 1 oder 2, **dadurch gekennzeichnet, dass** die Verbindung des ersten Steckerelements (14) mit der Leiterplatte (10) eine Lötverbindung ist.

4. Steuergerät (100) nach Anspruch 3, **dadurch gekennzeichnet, dass** das erste Steckerelement (14) mit an Ecken des Steckerelements (14) lokalisierten Lötpads (34) der Leiterplatte (10) verbunden ist.

5. Steuergerät (100) nach einem der vorhergehenden Ansprüche, **dadurch gekennzeichnet, dass** elektrische Verbindungen von Kontakten des ersten Steckerelements (14) zu Leiterbahnen (20) und/oder anderen elektrischen Kontakten der Leiterplatte (10) gelötete Verbindungen sind.

6. Steuergerät (100) nach einem der vorhergehenden Ansprüche, **dadurch gekennzeichnet, dass** die Leiterplatte (10) einen dielektrischen Träger aufweist, der eine erste Breitseite und eine zweite Breitseite aufweist, wobei die erste Breitseite eine in Form von Leiterbahnen (20) und metallischen Funktionsflächen strukturierte Metallschicht aufweist und wobei die zweite Breitseite eine in Form von Leiterbahnen (48) und metallischen Funktionsflächen strukturierte zweite Metallschicht aufweist.

7. Steuergerät (100) nach Anspruch 6, **dadurch gekennzeichnet, dass** der dielektrische Träger aus einer Einzellage aus dielektrischem Material besteht.

8. Steuergerät (100) nach Anspruch 6, **dadurch gekennzeichnet, dass** der dielektrische Träger wenigstens zwei Lagen aus dielektrischem Material aufweist.

9. Steuergerät (100) nach Anspruch 8, **dadurch gekennzeichnet, dass** zwischen zwei Lagen aus dielektrischem Material eine in metallische Strukturen (30) und/oder Funktionsflächen strukturierte metallische Schicht angeordnet ist.

10. Steuergerät (100) nach einem der vorhergehenden Ansprüche, **dadurch gekennzeichnet, dass** die elektrisch isolierende Pinhalterung (108) aus einem elektrisch isolierenden und mechanisch formstabilen Kunststoff besteht

11. Steuergerät (100) nach einem der vorhergehenden Ansprüche, **dadurch gekennzeichnet, dass** die elektrisch isolierende Pinhalterung (108) einen Positionierzylinder (110) aufweist, der genau passend in eine zu seiner Form komplementäre Aussparung in der Leiterplatte (10) eingesetzt wird.

## Claims

1. Control unit (100) comprising a printed circuit board (10) which has a first plug element (14) which is designed to be joined to a second plug element (16) to form a plug connection (12), wherein the printed circuit board (10) has a first side (22), which is equipped with first components (18) and has conductor tracks (20), and a second side (38), and wherein the first plug element (14) is securely mechanically connected to the first side (22) of the printed circuit board (10) in a contact and fastening region (26) of the first side (22), and has first electrical contacts (24) which are electrically conductively connected to at least one of the first components (18) by metal structures (28) running on or within the printed circuit board (10), and wherein the first plug element (14) is designed to be securely mechanically connected to the second plug element (16), wherein on one side of the printed circuit board (10), opposite the region of the printed circuit board (10) on which the first contacts (24) are arranged, at least one spacer (114) is located, which is designed in terms of its shape and arrangement to limit a bending of the printed circuit board (10) in a first direction (-Z), which occurs when the first plug element (14) and the second plug element (16) are plugged together, wherein the control unit has a housing (102) which delimits an interior (104) of the control unit (100), and in that the printed circuit board (10) is arranged in the housing (102) such that the printed circuit board (10) divides the interior (104) into a first interior region (40) delimited by the first side (22) and a second interior region (42) delimited by the second side (38), wherein electrical contacts of the first plug element (14) that are designed to produce the plug connection (12) lie entirely in the first interior region (40) of the control unit, wherein the control unit (100) has a pin holder (108) in which portions of the first contacts (24) are embedded, and wherein the pin holder (108) is supported on the inner face (110) of the control unit housing (102) in abutment therewith,
**characterized in that**
the pin holder (108) is electrically insulating and is supported on the inner face (110) of the control unit housing (102) in abutment therewith in such a way that forces that occur when the plug connection (12) is released are absorbed and deformation of the printed circuit board (10) in a second direction (+z) opposite the first direction (-z) is prevented, **in that** the second side (38) has a contact and fastening region (44) which is opposite the contact and fastening region (26) of the first side (22) and in which second electrical components (46) are arranged and/or in which conductor tracks (48) run, **in that** soldering pads (34), to which first contacts (24) are soldered, are arranged on the first side (22) of the printed circuit board (10), wherein the first contacts (24) are SMD soldering contacts that do not pass through the printed circuit board (10).

2. Control unit (100) according to claim 1, **characterized in that** the first plug element (14) is preferably securely mechanically connected to the printed circuit board (10) as an SMD component.

3. Control unit (100) according to claim 1 or 2, **characterized in that** the connection of the first plug element (14) to the printed circuit board (10) is a soldered connection.

4. Control unit (100) according to claim 3, **characterized in that** the first plug element (14) is connected to solder pads (34) of the printed circuit board (10) which are located on corners of the plug element (14).

5. Control unit (100) according to any of the preceding claims,
**characterized in that** electrical connections of contacts of the first plug element (14) to conductor tracks (20) and/or other electrical contacts of the printed circuit board (10) are soldered connections.

6. Control unit (100) according to any of the preceding claims, **characterized in that** the printed circuit board (10) has a dielectric carrier which has a first broad side and a second broad side, wherein the first broad side has a metal layer structured in the form of conductor tracks (20) and metal functional surfaces, and wherein the second broad side has a second metal layer structured in the form of conductor tracks (48) and metal functional surfaces.

7. Control unit (100) according to claim 6, **characterized in that** the dielectric carrier consists of a single layer of dielectric material.

8. Control unit (100) according to claim 6, **characterized in that** the dielectric carrier has at least two layers of dielectric material.

9. Control unit (100) according to claim 8, **characterized in that** a metal layer structured to form metal structures (30) and/or functional surfaces is arranged between two layers of dielectric material.

10. Control unit (100) according to any of the preceding claims, **characterized in that** the electrically insulating pin holder (108) consists of an electrically insulating and mechanically dimensionally stable plastics material.

11. Control unit (100) according to any of the preceding claims, **characterized in that** the electrically insulating pin holder (108) has a positioning cylinder (110) which is inserted in a precisely fitting manner into a recess in the circuit board (10) that is complementary to the shape thereof.

## Revendications

1. Appareil de commande (100) comportant une carte de circuits imprimés (10) qui présente un premier élément formant fiche (14) qui est conçu pour être assemblé avec un second élément formant fiche (16) pour former une liaison par fiches (12), dans lequel la carte de circuits imprimés (10) présente une première face (22) équipée de premiers composants (18) et présentant des pistes conductrices (20) et une seconde face (38), et dans lequel le premier élément formant fiche (14) est relié mécaniquement de manière fixe à la première face (22) de la carte de circuits imprimés (10) dans une zone de contact et de fixation (26) de la première face (22) et présente des premiers contacts (24) électriques, lesquels sont reliés de manière électriquement conductrice à au moins l'un des premiers composants (18) par des structures métalliques (28) s'étendant sur ou à l'intérieur de la carte de circuits imprimés (10), et dans lequel le premier élément formant fiche (14) est conçu pour être relié mécaniquement de manière fixe au second élément formant fiche (16), dans lequel au moins un espaceur (114) se trouve sur une face de la carte de circuits imprimés (10), en face de la zone de la carte de circuits imprimés (10) sur laquelle sont disposés les premiers contacts (24), lequel espaceur, par sa forme et son agencement, est conçu pour limiter une flexion de la carte de circuits imprimés (10) dans une première direction (-Z) qui se produit lors de l'enfichage du premier élément formant fiche (14) et du second élément formant fiche (16), dans lequel l'appareil de commande présente un boîtier (102) qui délimite un espace intérieur (104) de l'appareil de commande (100), et en ce que la carte de circuits imprimés (10) est disposée dans le boîtier (102) de sorte que la carte de circuits imprimés (10) divise l'espace intérieur (104) en une première zone d'espace intérieur (40) délimitée par la première face (22) et en une seconde zone d'espace intérieur (42) délimitée par la seconde face (38), dans lequel, pour réaliser la liaison par fiches (12), des contacts électriques aménagés du premier élément formant fiche (14) se trouvent entièrement dans la première zone d'espace intérieur (40) de l'appareil de commande, dans lequel l'appareil de commande (100) présente un support de broches (108) dans lequel des sections des premiers contacts (24) sont incorporées, et dans lequel le support de broches (108) s'appuie contre la face intérieure (110) du boîtier d'appareil de commande (102) en butant contre celle-ci,
**caractérisé en ce que**
le support de broches (108) est électriquement isolant et s'appuie contre la face intérieure (110) du boîtier d'appareil de commande (102) en butant contre celle-ci de telle sorte que, lors du détachement de la liaison par fiches (12), des forces apparaissant sont absorbées et une déformation de la carte de circuits imprimés (10) dans une second direction (+z) opposée à la première direction (-z) est empêchée, **en ce que** la seconde face (38) présente une zone de contact et de fixation (44) opposée à la zone de contact et de fixation (26) de la première face (22) et dans laquelle sont disposés des seconds composants (46) électriques et/ou dans laquelle s'étendent des pistes conductrices (48), **en ce que** sur la première face (22) de la carte de circuits imprimés (10) sont disposées des pastilles de soudage (34) sur lesquelles sont soudés les premiers contacts (24), dans lequel les premiers contacts (24) sont des contacts de soudage SMD qui ne traversent pas la carte de circuits imprimés (10).

2. Appareil de commande (100) selon la revendication 1,
**caractérisé en ce que** le premier élément formant fiche (14) est relié mécaniquement de manière fixe à la carte de circuits imprimés (10), de préférence sous la forme d'un composant SMD.

3. Appareil de commande (100) selon la revendication 1 ou 2,
**caractérisé en ce que** la liaison du premier élément formant fiche (14) avec la carte de circuits imprimés (10) est une liaison par soudage.

4. Appareil de commande (100) selon la revendication 3,
**caractérisé en ce que** le premier élément formant fiche (14) est relié à des pastilles de soudage (34) de la carte de circuits imprimés (10) localisées aux coins de l'élément formant fiche (14).

5. Appareil de commande (100) selon l'une des revendications précédentes, **caractérisé en ce que** des liaisons électriques de contacts du premier élément formant fiche (14) à des pistes conductrices (20) et/ou à d'autres contacts électriques de la carte de circuits imprimés (10) sont des liaisons soudées.

6. Appareil de commande (100) selon l'une des revendications précédentes, **caractérisé en ce que** la carte de circuits imprimés (10) présente un support diélectrique qui présente une première face large et une seconde face large, dans lequel la première face large présente une couche métallique structurée sous forme de pistes conductrices (20) et de surfaces fonctionnelles métalliques et dans lequel la seconde face large présente une seconde couche métallique structurée sous forme de pistes conductrices (48) et de surfaces fonctionnelles métalliques.

7. Appareil de commande (100) selon la revendication 6,
**caractérisé en ce que** le support diélectrique est constitué d'une couche unique en un matériau diélectrique.

8. Appareil de commande (100) selon la revendication 6,
**caractérisé en ce que** le support diélectrique présente au moins deux couches en un matériau diélectrique.

9. Appareil de commande (100) selon la revendication 8, **caractérisé en ce qu'**une couche métallique structurée en structures métalliques (30) et/ou en surfaces fonctionnelles est disposée entre deux couches en matériau diélectrique.

10. Appareil de commande (100) selon l'une des revendications précédentes, **caractérisé en ce que** le support de broches (108) électriquement isolant est constitué d'une matière plastique électriquement isolante et mécaniquement indéformable.

11. Appareil de commande (100) selon l'une des revendications précédentes, **caractérisé en ce que** le support de broches (108) électriquement isolant présente un cylindre de positionnement (110) qui est inséré de manière à être parfaitement ajusté dans un évidement dans la carte de circuits imprimés (10), lequel évidement est complémentaire à la forme dudit cylindre de positionnement.
